# EUROPEAN PATENT APPLICATION

(11) **EP 0 562 725 A2**
(43) Date of publication of application: **29.09.1993**
(21) Application number: 93301514.1
(22) Date of filing: 26.02.1993
(51) Int. Cl.: H01L 23/498, H01L 23/538

(54) **Adaptor element for modifying electrical connections to an electrical component**

(30) Priority: 04.03.1992 US 846301
(71) Applicant: INTERNATIONAL BUSINESS MACHINES CORPORATION, Armonk, N.Y. 10504 (US)
(72) Inventor: Frankeny, Richard Francis, Austin, Texas 78746 (US); Imken, Ronald Lann, Round Rock, Texas 78681 (US)
(74) Representative: Burt, Roger James, Dr.

(57) **Abstract**

The present invention relates to an adaptor element (20), for attachment to an electrical component (10) including at least one input/output contact point, comprising a body member (20, 22, 24, 26) adapted to be attached to the surface of the electrical component, at least one first type of contact (28) on the body member and adapted to be electrically connected to the input/output contact point (12) on the electrical component, and at least one second type of contact (32) on the body member, electrically connected to the first type of contact (28), and providing an input/output contact point for the adaptor element.

According to the invention the adaptor element is characterised in that the second type of contact (32) is spaced apart from the first type of component and the first type of contact is electrically connected to the input/output contact point on the electrically component, the second type of contact acts as an input/output contact point for the electrical component which is spaced apart from the input/output contact point on the electrical component.

## Description

This invention generally relates to connecting integrated electrical components such as circuit (IC) devices into an electrical circuit, for example, a computer system. In particular, an adaptor element is provided such that electrical connections between the input/output (I/O) contact points on an electrical component can effectively be re-positioned as required, thereby allowing different electrical interconnection configurations.

Generally, IC devices are placed flat in an electrical circuit, i.e. the largest surface is placed on a planar printed circuit board. More specifically, the major plane of the IC device lies parallel with the plane of the circuit board on which the IC device is mounted. These integrated circuit devices are then electrically connected to the circuitry on the board by using known methods, such as wire bonding or direct chip attach (DCA) technology. Additionally packaged IC devices using surface mount technology (SMT) or pin-through-hole (PTH) technology are also placed flat on the printed circuit board and then electrically attached thereto.

Adaptor elements for attaching IC devices to substrates on printed circuit boards are known. IBM Technical Disclosure Bulletin "Transmission Line Right Angle Connector" Vol. 26 No. 12 May 1984 page 6592 shows an interposer or adaptor element 3, having matching wiring, disposed between perpendicular IC device carriers 1, 2. US -A- 5,050,039 describes an IC device mounting arrangement wherein IC devices are attached, on one side, to a heat sink and the I/O contact points of the device are connected to vertically disposed interconnect boards. A flexible circuit is used to connect the interconnect boards to a motherboard.

Additionally, it is known to mount perpendicularly, with reference to a corresponding substrate, a plurality of IC devices on a support member, as shown in US -A- 4,982,264 and US -A- 5,059,557. In these arrangements electrical conductors are disposed on a surface of the support member to contact bonding pads located on the IC device. Further, IC devices can be mounted perpendicularly with respect to a substrate in a "free standing" configuration. US -A- 4,922,378 and US -A- 5,031,072 describe a base plate having channels therein for supporting perpendicularly mounted integrated circuit devices. The IC devices are electrically interconnected to the base plate through pads on each IC device and the base plate. The base plate and IC device assembly is then electrically interconnected to an underlying planar surface by interconnecting a plurality of baseboard pads and connector pads. IBM Technical Disclosure Bulletin "Vertical Chip Packaging" Vol. 20, No. 11A, April 1978, page 4339 discloses mounting IC devices perpendicularly on a substrate. The IC devices are either placed in a channel in the substrate, or supported by a foil "foot" bonded to the back of each IC device. The foot can also be used to supply electrical power to the IC device. Foil "fingers" are then used to electrically interconnect the IC device I/O contact points to the substrate. It can be seen that conventional perpendicular IC device mounting requires placement of I/O contact points at specific locations on the IC device. In known arrangements, this placement of I/O contact points occurs at the IC device fabrication level and requires custom made IC devices be acquired from IC device manufacturers. Of course, a great deal of packaging flexibility is lost if specific IC devices must be special ordered from the manufacturer. Further, availability problems may also exist if standard "off the shelf" types of IC devices cannot be purchased and used in the desired packaging configuration. Therefore, it would be advantageous to provide an adaptor element which will allow any type of IC device to meet the desired packaging configuration.

The object of the present invention is to provide an improved adaptor element for use with an electrical component which effectively re-positions the input/output contact points of the electrical component and to provide a combination of an electrical component formed with at least one input/out contact point and an adaptor element of the above type.

The present invention relates to an adaptor element, for attachment to an electrical component including at least one input/output contact point, comprising a body member adapted to be attached to the surface of the electrical component, at least one first type of contact on the body member and adapted to be electrically connected to the input/output contact point on the electrical component, and at least one second type of contact on the body member, electrically connected to the first type of contact, and providing an input/output contact point for the adaptor element.

According to the invention the adaptor element is characterised in that the second type of contact is spaced apart from the first type of contact, whereby, when the adaptor element is attached to the electrical component and the first type of contact is electrically connected to the input/output contact point on the electrical component, the second type of contact acts as an input/output contact point for the electrical component which is spaced apart from the input/output contact point on the electrical component.

According to another aspect the present invention relates to the combination of an electrical component including at least one input/output contact point and an adaptor element, in which the adaptor element comprises a body member attached to the surface of the electrical component, at least one first type of contact on the body member and electrically connected to the input/output contact point on the electrical component, and at least one second type of contact on the body member, electrically connected to the first type of contact, and providing an input/output contact point for the adaptor element.

According to the invention the combination is characterised in that the second type of contact is spaced apart from the first type of contact so that the second type of contact acts as an input/output contact point for the electrical component which is spaced apart from the input/output contact point on the electrical component.

According to a preferred embodiment of the invention the electrical component is an integrated circuit device.

In order that the invention may be more readily understood embodiments will now be described with reference to the accompanying drawings, in which:
Figure 1 is a perspective view of an IC device with an adaptor element in accordance with one embodiment of the present invention,
Figure 2 is a plan view of the assembly of Figure 1 wherein wirebonding is used to attach the IC device I/O contact points to the adaptor element,
Figure 3 shows materials which can be used to fabricate the adaptor element of Figure 1,
Figure 4 illustrates a first step in the fabrication process of the adaptor element of Figure 1,
Figure 5 is a cross-sectional view of the fabricated adaptor element,
Figure 6 is a perspective view of the adaptor element prior to its attachment to an IC device,
Figure 7 is another perspective view of the adaptor element showing its attachment to an IC device,
Figure 8 illustrates how an IC device with the adaptor element of Figure 1 can be incorporated into a module for attachment to a printed circuit board,
Figure 9 is another embodiment of the present invention wherein the electrical connection between the IC device and the adaptor element is made using tape automated bonding techniques,
Figure 10 is yet another embodiment of the present invention in which the adaptor element has two signal planes and an electrical connection between the IC device and the adaptor element is made through the annulus of a via (hole),
Figure 11 is a further embodiment of the present invention in which the adaptor element has a single signal plane interconnected to the IC device through a metallized via (hole), and
Figure 12 is a still further embodiment in which the adaptor element is elongated and includes a single circuit layer bent back on itself to interconnect with the IC device.

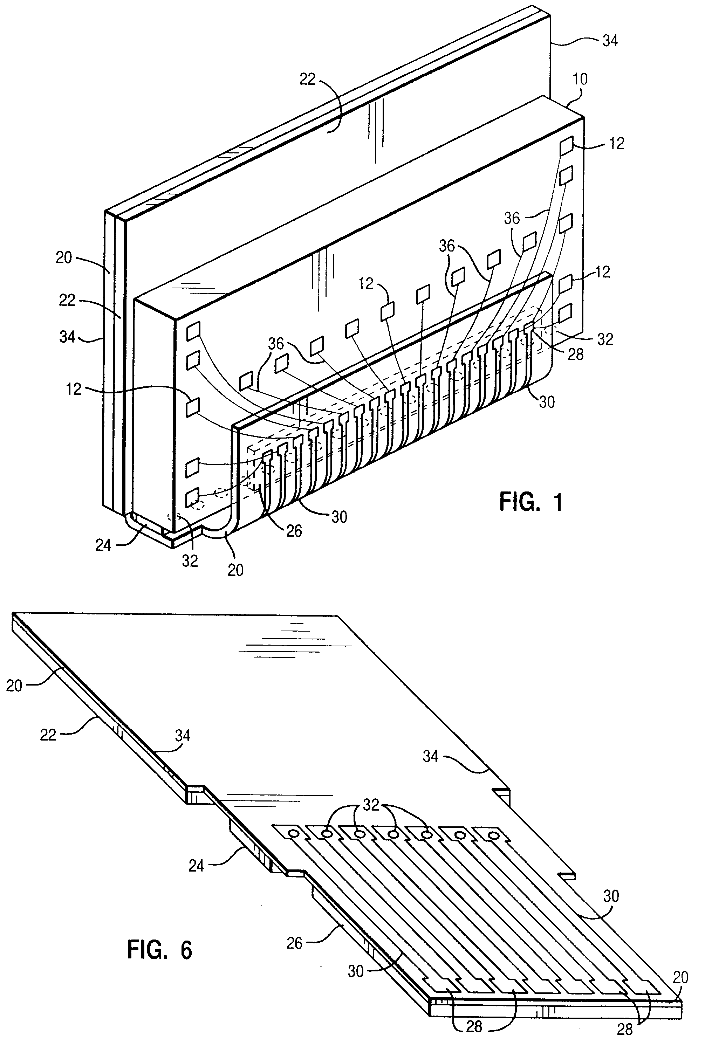

Referring to Figure 1, a perspective view of an IC device adaptor element in accordance with the present invention is shown. An integrated circuit (IC) device 10 is shown having a plurality of electrical connection input/output (I/O) contact points 12 on a surface thereof. IC device 10 may be one of any number of commercially available IC devices, such as dynamic random access memory (DRAM) devices, static random access memory (SRAM) devices, as well as any number of logic IC devices, and the like. It should be noted that IC device 10 is a standard unpackaged integrated circuit wherein I/O contact points 12 are formed on the IC device in any number of different configurations and with different metals thereon depending on the packaging application, e.g. wire bonding. No new processing is required during the fabrication of IC device 10 in order for it to be compatible with the adaptor element.

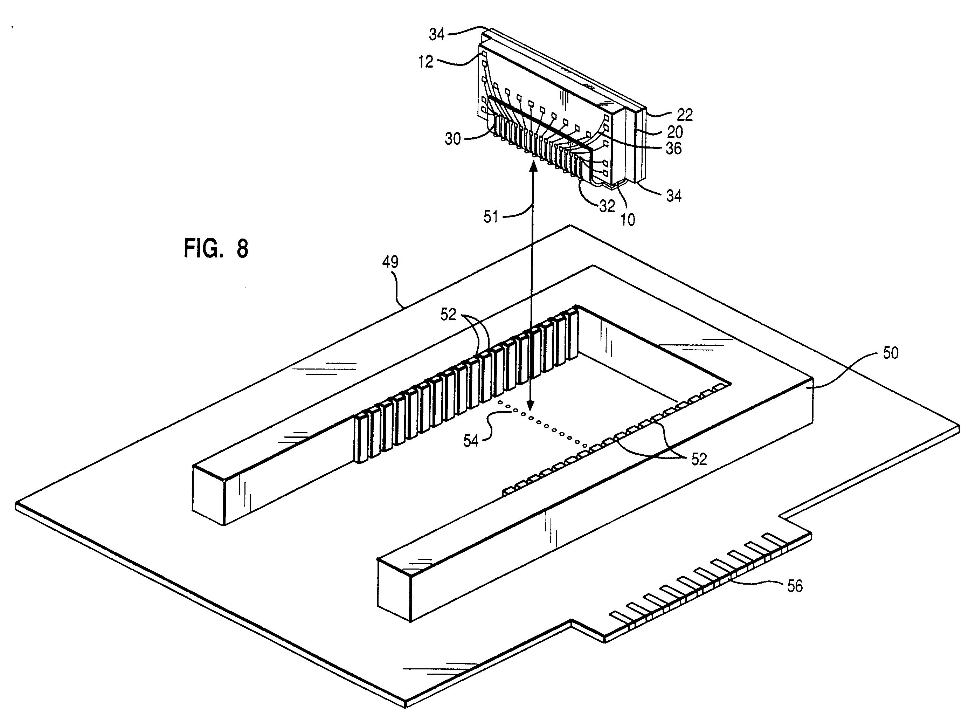

The adaptor element includes a flexible substrate layer 20 which extends around three sides of the IC device and has three distinct metal elements thereon. A heat spreader and stiffening element 22 is shown adjacent the side of IC device 10 opposite I/O contact points or pads 12. A backup element 24 is used to support input/output (I/O) connection pads 32 on the adaptor element. Similarly, another backup element 26 is used to support bonding pads 28 and signal lines 30 which extend to the I/O pads 32. It can be seen that flexible substrate 20 with the discrete metal elements 22, 24 and 26 can be bent around three sides of IC device 10. It should be noted that heat spreader element 22 and the adjacent portion of substrate 20 form wing portions 34 that extend past the ends of IC device 10. These wing portions 34 can be used to insert the adaptor element and the IC device into a mounting assembly, as shown in Figure 8 and discussed in more detail below. Pads 28 and signal lines 30 are disposed on the surface of flexible substrate 20 opposite support members 24 and 26. Pads 28 are covered with a joining metal, such as gold or nickel, by plating, sputtering or the like, to aid in the attachment of wires 36. Wires 36 are used to attach IC device pads 12 with adaptor element pads 28 using wire bonding technology as is known in the art. Signal lines 30 electrically interconnect pads 28 and I/O pads 32 such that IC device pads 12 are electrically connected with adaptor element pads 32, thereby effectively moving the positions of the I/O contact points of IC device 10.

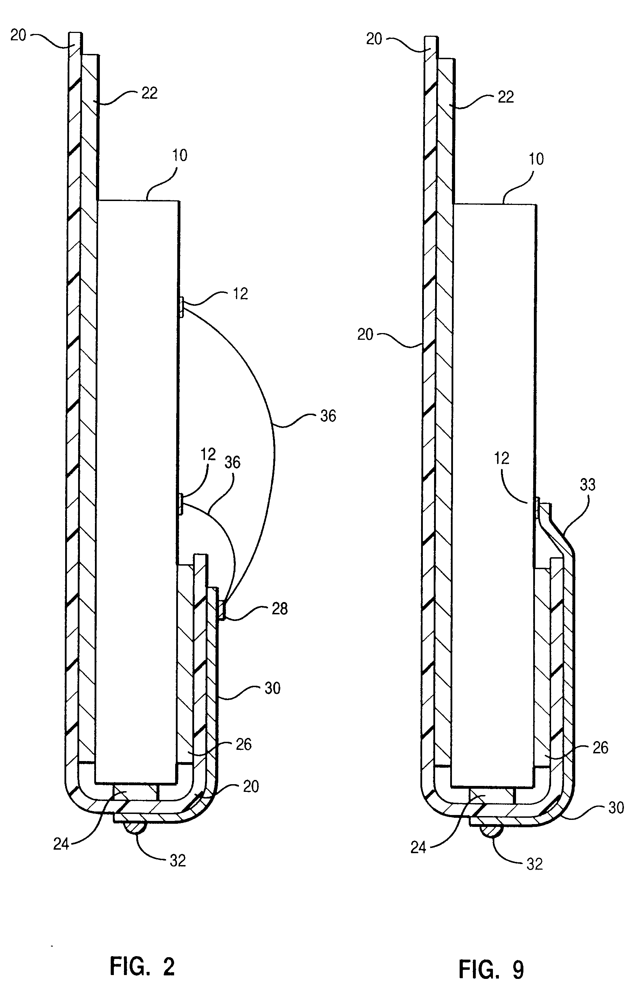

Figure 2 is a side view partly sectioned of the IC device adaptor element of Figure 1. IC device 10 is shown in abutting relation with heat spreader element 22. Back-up support elements 24 and 26 are also shown adjacent IC device 10. It can be seen how support elements 24 and 26 act as back-ups to adaptor element I/O pads 32 and pads 28, respectively. Flexible substrate 20 is shown bent around three sides of IC device 10. IC device I/O pads 12 are shown wire bonded to adaptor element pads 28 by wires 36. Circuit or signal lines 30, formed on the outside of substrate 20, electrically interconnect pads 28 with I/O pads 32. I/O pads 32 can typically be configured as controlled collapse chip connection (C4 type) interconnection points. Pads 12 of IC device 10 may also have a C4 type solder ball connection placed thereon such that IC device 10 can be directly mounted on a printed circuit board, or the like. Thus, the usefulness of the adaptor element can be seen since conventional direct attachment for IC device 10 will require a larger amount of a printed circuit board to be covered, or displaced, than by edge mounting IC device 10 having C4 type connections disposed along the narrow edge thereof. Those skilled in this particular art will understand that C4 type technology is well known and as such will not be described further herein.

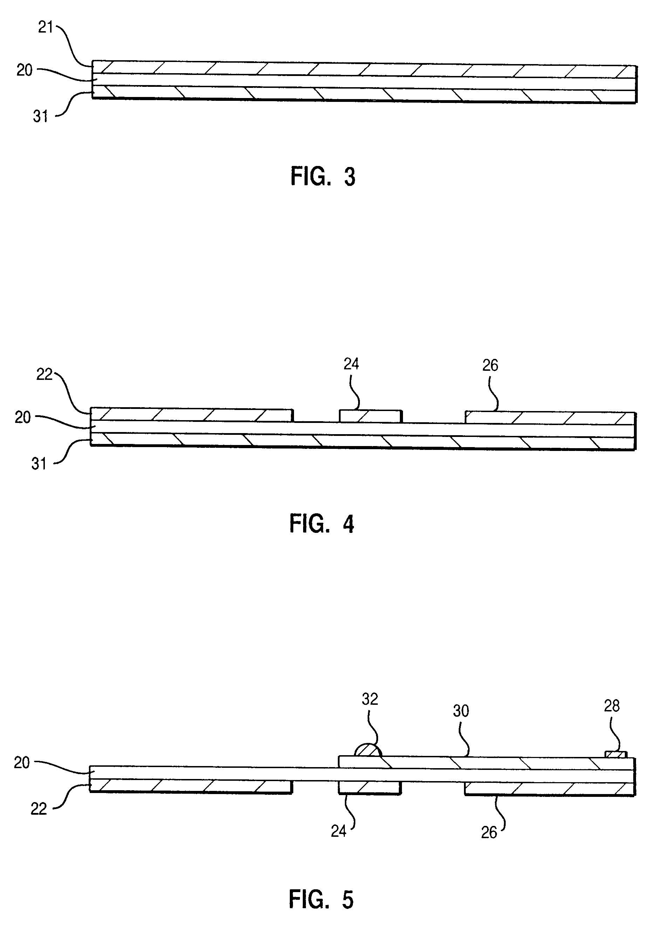

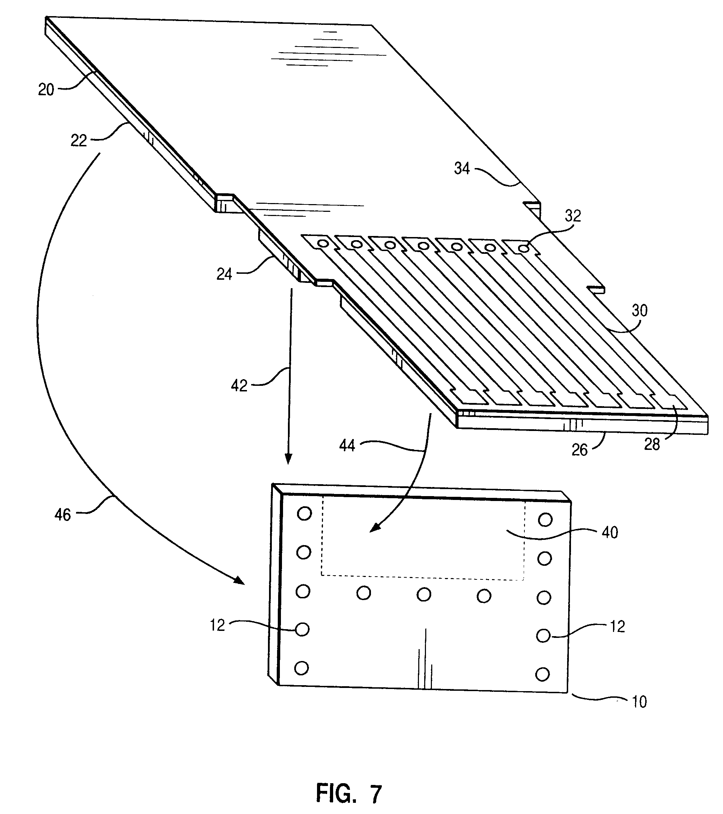

A description of the fabrication process for making the adaptor element illustrated in Figures 1 and 2 will now be described with reference to Figures 3-5. A polymer film such as a polyimide material is used for the flexible substrate 20 as shown in Figure 3 partly in cross-section. A stiffener layer 21 is then attached to one side of the polymer layer 20 by lamination, bonding or the like. The material of layer 21 may be any one of several thermally conductive materials e.g. metals. A copper layer 31 is also placed adjacent polyimide layer 20 on the side opposite stiffener layer 21 to form the substrate shown in cross-section in Figure 3. Stiffener layer 21 is then etched to form three distinct elements, i.e. heat spreader element 22 and back-up elements 24 and 26. Subsequent to forming the three distinct stiffening elements of layer 21, the copper layer 31 is etched to form the circuit or signal lines 30 as shown in Figures 5 and 6. Etching is a well known technique wherein caustic solutions are used to remove that portion of a material which is unnecessary such that the required portions remain. Subsequent to the formation of lines 30 on the flexible substrate 20, joining metal is placed near one end of the assembly to form pads 28. C4 type solder balls are then formed on substantially the opposite ends of the signal lines 30. The joining metal that will make up pads 28 may be gold or nickel and pads 32 will likely be made from a tin/lead solder or the like, as is known in the art. Additionally, it should be noted that other techniques of forming signal lines 30 on the surface of flexible substrate 20 can be used to form the adaptor element being described. For example, pattern plating may be used wherein a conductive seed layer is sputtered onto substrate layer 20 and circuit lines 30 are then selectively plated thereon in the desired locations through a dielectric mask. The dielectric mask is removed by washing, or the like, and the seed layer is subsequently removed by flash etching, thereby leaving circuit lines 30 in desired locations on the surface of flexible substrate 20.

Figure 6 is a perspective view of the adaptor element shown in Figure 5, prior to its placement around an integrated circuit device 10. Flexible substrate 20 is shown having pads 28 and circuit lines 30 formed thereon. Additionally, connection pads 32 are shown electrically connected to pads 28 through lines 30. Heat spreader element 22 and the back-up elements 24 and 26 are also shown attached to flexible substrate layer 20. Wing portions 34 can be seen which will be used to connect and align the IC device 10 and adaptor element assembly on a printed circuit board, as described below with reference to Figure 8.

Placement of the adaptor element described around an integrated circuit device will now be described with reference to Figure 7. First, the back-up element 24 is placed along one edge of IC device 10 as shown by arrow 42 and then bonded thereto by conventional means such as gluing, or the like. Subsequently, back-up element 26 is placed over portion 40 of IC device 10, as shown by arrow 44, and bonded thereto. It should be noted that the width of the adaptor element is designed so as not to cover any IC device I/O pads 12 and to directly correspond to area 40 of IC device 10. The configuration of the adaptor element can be changed according to the configuration of I/O pads on the IC device 10 being used. During fabrication of the adaptor element, the width thereof is regulated by cutting, stamping, or the like an element having the desired dimensions from a sheet of substrate such as shown in Figures 3-5. Subsequent to bonding of the back-up element 26 to IC device 10 heat spreader element 22 is then bent around adjacent to the side of IC device 10 opposite I/O pads 12 and bonded thereto, as shown by arrow 46. Pads 12 can then be electrically interconnected with pads 28 by techniques such as wire bonding, or the like. Thus, an assembly of an adaptor element and IC device which effectively re-positions the IC device I/O pads from one face of the IC device to a single edge of the IC device, thereby enhancing connectability of the IC device 10 in high density packaging applications, is shown. It should be noted that the bonding material may be chosen to electrically insulate support elements 22, 24, 26 from the surface of IC device 10 in order to prevent any potential electrical short circuits from occurring between IC device I/O pads. Alternatively, an electrically conductive bonding material can be used if the support elements are to be used as a ground plane, or the like.

Figure 8 is an application of the adaptor element described wherein a printed circuit board 49 is shown with a high density packaging mounting assembly 50 affixed thereto. The IC device and adaptor element assemblies are held in place on board 49 by the mounting assembly 50 when the wing portions 34 of each adaptor element are slid into corresponding grooved portions 52 of the mounting assembly 50 as shown by arrow 51. Connection pads 54 are formed on the surface of board 49 and are in electrical connection with connectors 56 formed on the edge of board 49. Connection pads 54 will correspond in position with solder I/O pads 32 of the adaptor element such that when card 49 is plugged into a computer printed circuit board, or the like, a central processing unit is capable of communicating with IC device 10 through connectors 56, card pads 54, solder I/O pads 32, signal lines 30, connection pads 28, wire bonded lines 36 and IC device I/O pads 12.

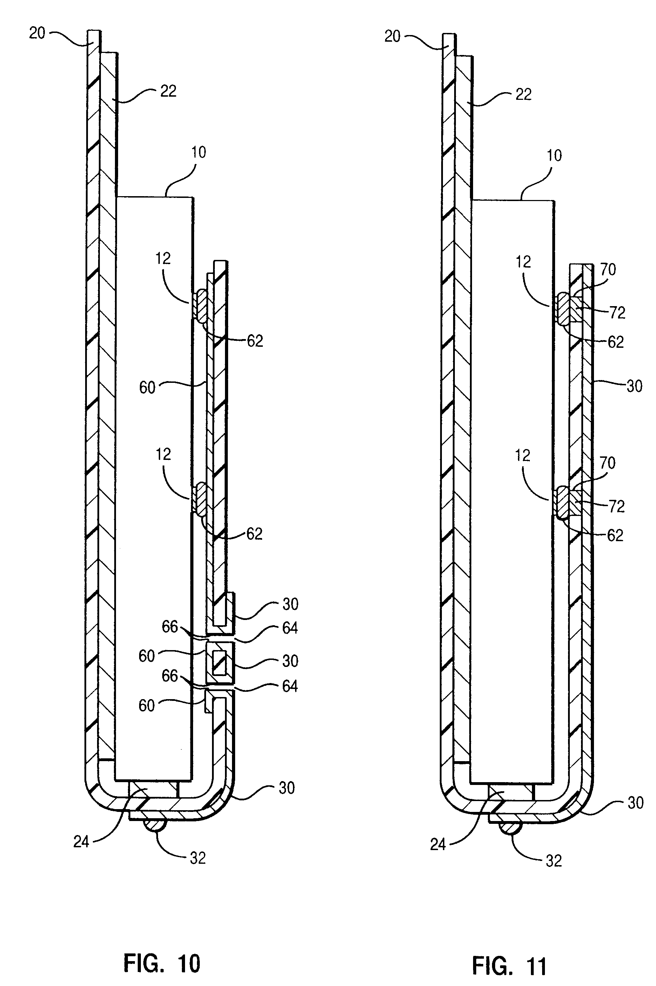

Other embodiments of the present invention will now be described beginning with reference to Figure 9. Basically, the following embodiments will describe an adaptor element capable of being electrically connected to IC device 10 without the need for using wire bonding technology. The adaptor element of Figure 9 is fabricated similarly to the adaptor element fabricated by the process described with reference to Figures 3-5. However, subsequent to the formation of the signal lines 30 on flexible substrate layer 20, the end portion of polymer carrier layer 20 adjacent to lines 30 is removed such that the circuit lines 30 extend past the end of layer 20. These circuit line extensions 33 are flexible and are then attached to the I/O pads 12 of IC device 10 by techniques commonly used in tape automated bonding (TAB) technology, e.g. hot bar reflow, ultra sonic welding, thermal welding, or the like. Thus, it can be seen how the adaptor element can be affixed to IC device 10 and electrically connected thereto using TAB technology rather than the wire bonding described with reference to Figures 1-8.

Referring to Figure 10, the flexible polymer substrate 20 is shown disposed around IC device 10 having only a heat spreader element 22 and a back-up element 24 adjacent IC device 10. It can be seen that two signal layers are present one on each side of substrate 20. Circuit lines 30 and C4 type I/O pads 32 are present and extend along the outside of flexible substrate layer 20. Inner circuit lines 60 are shown on the inside of layer 20 and extend a sufficient distance to overlap and align with outer circuit lines 30. Vias or holes 64 are formed through both sets of circuit lines 30, 60 and polymer layer 20. Electrical conductive material 66 is then placed around the annulus of each via 64 by plating, electrodeposition, or the like. Thus, it can be seen that circuit lines 60 are in electrical connection with corresponding ones of circuit lines 30 through the electrically conductive annulus 66 of each via 64. It should be noted that vias 64 can be formed in lines 30, 60 and layer 20 by means known in the art such as laser ablation, punching, drilling, chemical etching, or the like. Next, C4 type solder balls 62 are placed either on IC device I/O pads 20, or on inner circuit lines 60. Pads 12 and corresponding circuit lines 60 are then aligned and pressed together with C4 type solder balls 62 intermediate therebetween. Of course, methods other than C4 type technology can be used to join the adaptor element (circuit lines 60) with I/O pads 12, such as pad-to-pad joining techniques using appropriate joining metals. Subsequent to the connection of I/O pads 12 with circuit lines 60 it can be seen how IC device I/O pads 12 are now in electrical connection with corresponding adaptor I/O pads 32 through inner circuit lines 60, through each via annulus 66 and outer circuit lines 30.

Another embodiment of the present invention is shown in Figure 11, wherein a single signal plane adaptor element is used. Again, flexible substrate 20 is shown with heat spreader element 22 and back-up element 24 attached thereto and adjacent the IC device 10. Circuit lines 30 are formed as previously described along the outside of layer 20 and extend to the end thereof, as shown in Figure 11. Vias 70 are formed within layer 20 and filled with electrically conductive material 72. In a preferred embodiment vias 70 are in fact a pattern of holes corresponding to the IC device I/O pads 12 and are laser ablated or chemically removed from polymer carrier layer 20 directly beneath circuit lines 30 of the adaptor element. That is, the vias are formed after circuit lines 30 are placed on flexible substrate 20. The appropriate joining metal 72, such as solder or the like, is then plated or otherwise disposed in each via 72. Again, C4 type joining technology can be used as shown by pads 62 to electrically connect IC device I/O pads 12 with joining metal 72 of each via 70. In this embodiment electrical connection is made from IC device I/O pads 12 through C4 type pads 62, metal 72 in each via 70, circuit lines 30 to corresponding adaptor I/O pads 32. It should be noted that substrate 20 can also be prepunched with vias 70 and the foil layer 31 subsequently bonded thereto (Figure 3). However, when using this technique the bonding material, e.g. epoxy, enters vias 70 and must be removed prior to placing conductive material 72 therein.

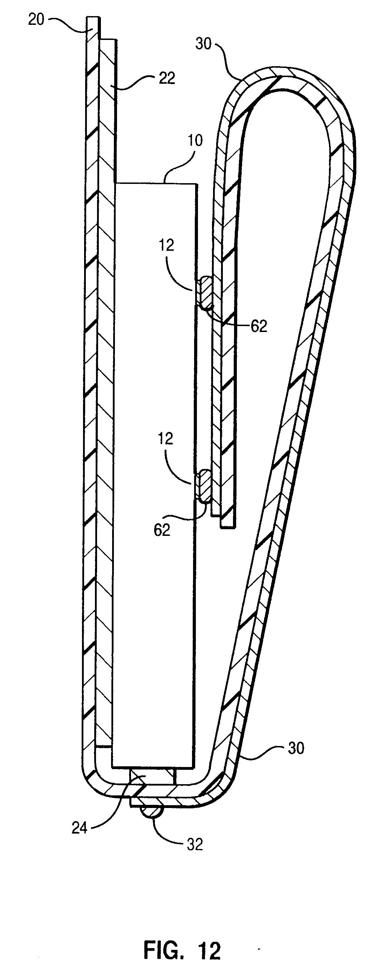

Figure 12 shows flexible layer 20 with heat spreader element 22 and back-up element 24 attached thereto and adjacent to IC device 10. In the embodiment of Figure 12, layer 20 is extended a sufficient distance such that the adaptor element can be wrapped around and the circuit lines 30 on the outside thereof will now be adjacent to I/O pads 12 of IC device 10. Thus, a single signal plane adaptor element can be fabricated as described previously and appropriate joining metal, such as C4 type pads 62, can be placed on circuit lines 30 such that when the adaptor element is wrapped around the IC device they will correspond to I/O pads 12 on IC device 10. Alternatively, C4 type pads 62 can be placed on pads 12 such that when the adaptor element is wrapped around the IC device and circuit lines 30 are adjacent to I/O pads 12, pads 62 will be aligned with the corresponding circuit lines 30. In this manner, it can be seen that IC device I/O pads 12 are connected to corresponding ones of adaptor element I/O pads 32 through C4 type pads 62 and corresponding circuit lines 30.

It can be seen that the adaptor element described is capable of effectively repositioning the I/O pads or contact points of an integrated circuit device 10 such that the IC device I/O pads are effectively aligned along the edge of the IC device/adaptor element assembly. In this manner, high density packaging of integrated circuits is possible using I/C devices having differently configured I/O contact points. The present invention is particular useful in high density memory packaging, but it not limited thereto and is applicable to any type of IC device packaging wherein the original IC device I/O contact points must effectively be repositioned.

## Claims

1. An adaptor element (20), for attachment to an electrical component (10) including at least one input/output contact point (12), comprising
a body member (20, 22, 24, 26) adapted to be attached to the surface of said electrical component, and
at least one second type of contact (32) on said body member, electrically connected to said first type of contact (28), and providing an input/output contact point for said adaptor element,
characterised in that
said second type of contact (32) is spaced apart from said first type of contact (28),
whereby,
when said adaptor element is attached to said electrical component and said first type of contact is electrically connected to said input/output contact point on said electrical component, said second type of contact acts as an input/output contact point for said electrical component which is spaced apart from said input/output contact point on said electrical component.

2. An adaptor element as claimed in Claim 1 characterised in that said first type of contact and said second type of contact are positioned on said body member in such a way that, when said adaptor element is attached to said electrical component, said first type of contact and said second type of contact are positioned adjacent to two different surfaces of said electrical component.

3. An adaptor element as claimed in Claim 2 characterised in that said body member has two portions extending substantially at right angles to one another, said first type of contact is positioned on one of said body portions, and said second type of contact is positioned on the other of said body portions.

4. An adaptor element as claimed in Claim 2 characterised in that said body member is substantially U-shaped and is adapted to fit closely to three surfaces of said electrical component.

5. An adaptor element as claimed in any one of the preceding claims characterised in that said body member comprises a flexible portion (20) and stiffener elements (24, 26) attached to said flexible portion adjacent to said contacts.

6. The combination of an electrical component (10 including at least one input/output contact point (12) and an adaptor element (20),
in which said adaptor element comprises
a body member (20, 22, 24, 26) attached to the surface of said electrical component,
at least one first type of contact (28) on said body member and electrically connected to said input/output contact point (12) on said electrical component, and
at least one second type of contact (32) on said body member, electrically connected to said first type of contact (28), and providing an input/output contact point for said adaptor element,
characterised in that
said second type of contact is spaced apart from said first type of contact so that said second type of contact acts as an input/output contact point for said electrical component which is spaced apart from said input/output contact point on said electrical component.

7. A combination as claimed in Claim 6 characterised in that said first type of contact and said second type of contact are positioned on said body member in such a way that said first type of contact and said second type of contact are positioned adjacent to two different surfaces of said electrical component.

8. A combination as claimed in Claim 7 characterised in that said body member has two portions extending substantially at right angles to one another, said first type of contact is positioned on one of said body portions, and said second type of contact is positioned on the other of said body portions.

9. A combination as claimed in Claim 8 characterised in that said body member is substantially U-shaped and fits closely to three surfaces of said electrical component.

10. A combination as claimed in any one of the preceding claims 6 to 9 characterised in that said electrical component (10) is an integrated circuit device.
